# EUROPÄISCHE PATENTANMELDUNG

(11) **EP 2 782 244 A1**
(43) Veröffentlichungstag der Anmeldung: **24.09.2014**
(21) Anmeldenummer: 14000938.2
(22) Anmeldetag: 14.03.2014
(51) Int. Cl.: H03B 11/02, F41H 13/00

(54) **Vorrichtung zur Erzeugung von Mikrowellen**

(30) Priorität: 23.03.2013 DE 102013005095
(71) Anmelder: Diehl BGT Defence GmbH & Co. KG, 88662 Überlingen (DE)
(72) Erfinder: Stark, Robert, Dr., 91438 Bad Windsheim (DE)
(74) Vertreter: Diehl Patentabteilung

(57) **Zusammenfassung**

Vorrichtung zur Erzeugung von Mikrowellen, umfassend mehrere separat ansteuerbare Mikrowellengeneratoren mit jeweils einem Resonator mit jeweils einer Kondensatorstruktur umfassend zwei Elektroden, die über eine Funkenstrecke getrennt sind, sowie den Mikrowellengeneratoren zugeordnete Hochspannungsversorgungsmittel zur Aufladung der einzelnen Kondensatorstrukturen, wobei die jeweilige Kondensatorstruktur über einen Durchschlag der Funkenstrecke entladbar ist und wobei die einzelnen Kondensatorstrukturen über die Hochspannungsversorgungsmittel (13) auf eine Spannung unterhalb der Durchschlagspannung der einzelnen Funkenstrecken (7) aufladbar sind, und dass jeder Funkenstrecke (7) eine Triggereinrichtung (15) zur Auslösung eines Durchschlags der jeweiligen Funkenstrecke (7) zugeordnet ist, wobei die Triggereinrichtungen (15) über eine gemeinsame Steuerungseinrichtung (16) individuell ansteuerbar sind.

## Beschreibung

Die Erfindung betrifft eine Vorrichtung zur Erzeugung von Mikrowellen, umfassend mehrere separat ansteuerbare Mikrowellengeneratoren mit jeweils einem Resonator mit jeweils einer Kondensatorstruktur umfassend zwei Elektroden, die über eine Funkenstrecke getrennt sind, sowie den Mikrowellengenaratoren zugeordnete Hochspannungsversorgungsmittel zur Aufladung der einzelnen Kondensatorstrukturen, wobei die jeweilige Kondensatorstruktur über einen Durchschlag der Funkenstrecke entladbar ist.

Die Funktion eines solchen Mikrowellengenerators beruht darauf, dass ein Hochspannungsversorgungsmittel, also eine geeignet ausgelegte Hochspannungsquelle wie beispielsweise eine gemäß dem Prinzip der Marx'schen Stoßspannungsschaltung parallel aufgeladene und dann in Serie geschaltete Kondensatorbatterie, über eine Funkenstrecke kurz geschlossen und damit entladen wird. Die Funkenstrecke ist Teil einer Kondensatorstruktur, die in dem Resonator, üblicherweise einem sogenannten DS-Resonator (DS = Damped Sinusoid), ausgebildet ist. Über sie sind die beiden Elektroden, die die Kondensatorstruktur bilden, getrennt, über die Funkenstrecke erfolgt die Entladung. Diese Kapazität bildet mit den physikalischen Eigenschaften des Schalterplasmas in der Funkenstrecke sowie im Zusammenhang mit den elektrischen Verschaltungen einen Schwingkreis, der aus einem ohmschen Widerstand R, einer Induktivität L und einer Kapazität C besteht. Diese Kapazität wird über eine Ladeimpedanz auf Spannungen bis in den 100 kV- bis MV-Bereich aufgeladen, wobei es mit zunehmender Ladespannung schließlich, dem Paschengesetz folgend, zum Durchbruch kommt.

Infolge dieses Durchbruchs respektive Kurzschlusses entstehen stark oszillierende Entlade- oder Kurzschlussströme mit steiler Flanke im Resonator, die eine Mischung sehr hoher Frequenzen enthalten, die in der Regel über eine Antenne als Mikrowellenenergie mit einem breitbandigen, vom Frequenzgemisch abhängigen Spektrum abgestrahlt wird. Dieses breitbandige Mikrowellenspektrum weist eine so hohe Energiedichte auf, dass in der Umgebung eines solchen Mikrowellengenerators der Funkverkehr zumindest beeinträchtigt und Eingangskreise elektronischer Schaltungen aufgrund von Resonanzeffekten gestört oder sogar zerstört werden können. Ein Mikrowellengenerator dieser Art ist beispielsweise aus DE 10 2005 002 279 A1 bekannt. Die dort vorgesehene Konfiguration des Resonators umfasst eine äußere topfartige Elektrode, in die eine innere, entsprechend formkomplementäre Polelektrode eingesetzt ist, an die sich das Antennenteil anschließt. Der grundsätzliche Aufbau eines solchen Mikrowellengenerators ist bekannt.

Mitunter ist es gewünscht, abhängig von der gegebenen Situation respektive etwaiger über den Mikrowellenpuls zu beeinträchtigender Gegenstände ein sogenanntes "Beam Steering" oder "Beam Forming" zu realisieren. Hierzu werden mehrere Mikrowellengeneratoren verwendet, die jeweils einen Resonator, üblicherweise einen DS-Resonator, aufweisen und jeweils separat zur Abgabe eines HPEM-Pulses, also eines hochenergetischen Mikrowellenpulses, ausgebildet sind. Es wird nun versucht, diese einzelnen Mikrowellengeneratoren in einer definierten zeitlichen Abfolge zu zünden, so dass die separat abgegebenen HPEM-Pulse in einem bestimmten Phasenbezug zueinander generiert werden und sich in der gewünschten Weise überlagern, respektive es durch Reflexion der Pulse zu einer Strahlformung oder Strahlbündelung kommt. Das heißt, dass durch eine geschickte zeitliche Synchronisation ein bestimmter Phasenbezug der abgestrahlten Wellenfronten zueinander eingestellt beziehungsweise realisiert werden soll, derart, dass sich durch Überlagerungs- oder Reflexionseffekte etc. eine bestimmte, gewünschte Pulsform ergibt.

Gerade die Einstellung des hierfür erforderlichen exakten Phasenbezugs der einzelnen abgestrahlten Wellenfronten zueinander, mithin also die zeitliche Synchronisation der Erzeugung der einzelnen HPEM-Pulse ist jedoch nur mit großer Ungenauigkeit möglich. Bei bekannten Mikrowellengeneratoren erfolgt die Zündung dann, wenn, dem Paschengesetz folgend, eine hinreichend hohe Ladespannung an den Kondensatorstrukturen anliegt, so dass die Zündspannung erreicht respektive überschritten wird und es zum Kurzschluss über die Funkenstrecke kommt. Die tatsächlich benötigte Zündspannung ist jedoch von diversen Parametern abhängig. Unmittelbar dem Paschengesetz folgend hängt sie vom Druck des Isoliergases, das sich im Inneren des Generators respektive des DS-Resonators befindet, und der Art des Isoliergases ab, üblicherweise wird SF₆ verwendet. Ferner ist die Zündspannung vom Elektrodenabstand sowie der Elektroden- respektive Funkstreckengeometrie abhängig, wie auch der Oberflächenbeschaffenheit der Elektroden insbesondere im Bereich der Funkenstrecke und der Reinheit des Gesamtsystems. Hieraus resultieren letztlich Schwankungen der Zündspannung im Bereich von bis zu 20 % bezogen auf die "theoretische" Zündspannung, das heißt, dass der genaue Durchbruch letztlich zeitlich nicht hochgenau definierbar respektive einstellbar ist. Um einen grundsätzlichen Phasenbezug zu realisieren, wird versucht, diesen über unterschiedliche Kabellaufzeiten zwischen dem Hochspannungsversorgungsmittel und den DS-Resonatoren einzustellen. Eine aktive Steuerung ist hierüber jedoch nicht möglich.

Ferner wurde versucht, durch Triggerung der Hochspannungsversorgungsmittel, also beispielsweise der einzelnen Marx'schen Generatoren, eine entsprechend zeitlich exakte Steuerung des Phasenbezugs zu erhalten. Aufgrund der hohen Ungenauigkeit im Zündzeitpunkt der einzelnen Generatoren, resultierend aus dem Jitter der Funkenstrecken und des additiven Verhaltens der Jitterwerte der einzelnen Zündgeneratoren wie auch der Resonatoren innerhalb des Gesamtsystems, lässt sich auch hierüber keine ausreichend hohe Zeitschärfe der Schaltprozesse und damit keine zeitlich exakte Steuerung der Phasen der Wellenfronten realisieren. Ein "Beam Steering" oder "Beam Forming" durch gezielte Überlagerung einzelner HPEM-Pulse ist damit nicht möglich.

Der Erfindung liegt damit das Problem zugrunde, eine Vorrichtung der eingangs genannten Art anzugeben, die in der Lage ist, mit zeitlich exakter Auflösung die einzelnen Generatoren zu zünden, um eine entsprechende Strahlformung zu ermöglichen.

Zur Lösung des Problems ist erfindungsgemäß vorgesehen, dass die einzelnen Kondensatorstrukturen über die Hochspannungsversorgungsmittel auf eine Spannung unterhalb der Durchschlagspannung der einzelnen Funkenstrecken aufladbar sind, und dass jeder Funkenstrecke eine Triggereinrichtung zur Auslösung eines Durchschlags der jeweiligen Funkenstrecke zugeordnet ist, wobei die Triggereinrichtungen über eine gemeinsame Steuerungseinrichtung individuell ansteuerbar sind.

Bei der erfindungsgemäßen Vorrichtung erfolgt eine individuelle Triggerung der einzelnen Resonatoren, denen jeweils eine separate Triggereinrichtung zugeordnet ist. Über die gemeinsame Steuerungseinrichtung ist jede Triggereinrichtung individuell ansteuerbar, so dass folglich über die Steuerungseinrichtung eine exakte zeitliche Synchronisation der einzelnen Zündzeitpunkte der einzelnen Generatoren erreicht werden kann. Die zum Generator externen Hochspannungsversorgungsmittel, also beispielsweise der einzelne oder die mehreren Marx'schen Generatoren, dienen der Aufladung der Kondensatorstruktur auf eine Spannung hinreichend unterhalb der Zündspannung, so dass es allein hierüber nicht zu einer Entladung kommt. Die Entladung erfolgt erst, wenn über die Triggereinrichtung die jeweilige Funkenstrecke gezündet wird, mithin hierüber also gezielt der Kurzschluss initiiert wird. Das heißt, dass erfindungsgemäß eine spezifische generatorbezogene Triggerung innerhalb der jeweiligen HPEM-DS-Resonatoren innerhalb des gesamten Systems als integriertem pulsformendem Netzwerk gegeben ist. Durch diese Triggerung innerhalb der einzelnen Resonatoren werden vorteilhaft sämtliche statistischen Effekte eliminiert, die in der bisherigen Anwendung ungetriggerter DS-Resonätoren zusammen mit einem ungetriggerten oder getriggerten Hochspannungsgenerator wie beispielsweise dem Marx'schen Generator kumulieren und sich negativ auf das Delay, den Jitter und die Amplitudenstatistik der Ausgangspulse auswirken. Denn die einzelnen getriggerten DS-Resonatoren ermöglichen es mit besonderem Vorteil, die zeitlichen statistischen Schwankungen bedingt durch den Jitter des Marx'schen Generators vollständig zu eliminieren und folglich das Zündverhalten des Resonators von dem Verhalten des Hochspannungsgenerators zu separieren. Gleichzeitig ermöglicht der getriggerte Resonator die statistischen Effekte in der Amplitudenschwankung des Ausgangspulses am Resonator deutlich zu reduzieren, diese zu kontrollieren und reproduzierbar einzustellen. Ferner ist es auch möglich, den Resonator unterhalb seiner Selbstdurchbruchscharakteristik zu betreiben respektive zu zünden und damit auch die Amplitudenhöhe des Ausgangspulses nahezu unabhängig von der Durchbruchsspannung der Funkenstrecke im Resonator zu variieren. Denn über die Triggereinrichtung kann weitestgehend unabhängig von der letztendlich anliegenden Ladespannung seitens des Hochspannungsgenerators die Zündung erfolgen.

Damit ermöglicht die erfindungsgemäße Vorrichtung eine zeitlich hochgenaue Synchronisierung der einzelnen Generatoren, mithin also der einzelnen erzeugten Wellenfronten, so dass diese sich in einer gewünschten Weise zur Bildung eines Gesamtpulses überlagern können und folglich eine aktive Strahlform respektive Strahlbündelung möglich ist. Denn für die Synchronisation respektive Phasensteuerung der Wellenfronten ist nur noch der Jitter der einzelnen Resonatoren maßgeblich. Zusätzlich führt eine direkte Triggerung des Resonators zu einer deutlichen Verbesserung des Zündverhaltens und damit zu einer Verkleinerung auch des zeitlichen Jitters der einzelnen Resonatoren, so dass im Ergebnis nur noch die zeitliche Triggerung der einzelnen Resonatoren miteinander abgeglichen werden muss, um einen entsprechenden Phasenbezug zu erhalten.

Den Mikrowellengeneratoren kann ein gemeinsames Hochspannungsversorgungsmittel, also beispielsweise ein gemeinsamer Marx'scher Generator, zugeordnet sein. Alternativ kann jedem einzelnen Mikrowellengenerator ein eigenes Hochspannungsversorgungsmittel zugeordnet sein, das heißt, dass die Aufladung jedes Resonators beispielsweise über einen eigenen Marx'schen Generator erfolgt, so dass folglich neben einem Array aus Mikrowellengeneratoren letztlich auch ein Array aus Hochspannungsgeneratoren vorgesehen ist.

Die Hochspannungsversorgungsmittel, gleich welcher Art sie sind, laden die Kondensatorstrukturen bevorzugt auf maximal ca. 90 %, insbesondere nur auf maximal ca. 80 % der resonatorspezifischen Durchschlagspannung auf. Die Aufladung sollte hinreichend weit unterhalb der theoretischen, sich aus dem Paschengesetz ergebenden Durchschlagspannung der Funkenstrecke liegen, um Sicherheit zu haben, dass kein ungewolltes Zünden erfolgt.

Verwendbare Triggereinrichtungen können nach unterschiedlichen Verfahren arbeiten. Die technische Auslegung und die physikalischen Eigenschaften der verwendeten Triggereinrichtung orientieren sich maßgeblich an den spezifischen Eigenschaften und Anforderungen der jeweiligen DS-Resonatoren. Neben der geforderten Hochspannungsfestigkeit im Bereich einiger 100 kV und dem Betrieb in einer Hochdruckumgebung von mehreren bar bis zu 100 bar ist die Triggerung derart zu realisieren, dass ausreichend primäre Ladungsträger zur Verfügung gestellt werden, um die Triggerung in ausreichender Schnelligkeit und Zeitschärfe sicher zu stellen, gleichzeitig diese aber die physikalischen beziehungsweise elektrischen und elektromagnetischen Eigenschaften (Impedanz, Wellenleiter, Antenne) des Resonators unterstützt oder zumindest nicht beeinträchtigt.

Die Triggereinrichtungen können als elektrische arbeitende Trigger ausgebildet sein, beispielsweise als Überspannungstrigger, Feldverzerrungstrigger, Ladungsträgerinjektionstrigger, Elektronenstrahltrigger oder als Oberflächengleitfunkentrigger.

Alternativ können die Triggereinrichtungen auch als optisch arbeitende Trigger ausgebildet sein, beispielsweise in Form von Lasertriggern, Röntgenstrahlungstriggern oder UV- oder VUV-Strahlungstriggern. Auch Kombinationen unterschiedlich arbeitender Trigger sind grundsätzlich innerhalb des Resonatorarrays denkbar.

Weitere Vorteile, Merkmale und Einzelheiten der Erfindung ergeben sich aus den im Folgenden beschriebenen Ausführungsbeispielen sowie anhand der Zeichnungen. Dabei zeigen:
- Fig. 1: eine Prinzipdarstellung eines Mikrowellengenerators,
- Fig. 2: eine Prinzipdarstellung der erfindungsgemäßen Vorrichtung,
- Fig. 3: ein Prinzipdiagramm zur Darstellung der Paschenkurve, und
- Fig. 4: verschiedene Ausgestaltungen von verwendbaren Triggereinrichtungen.

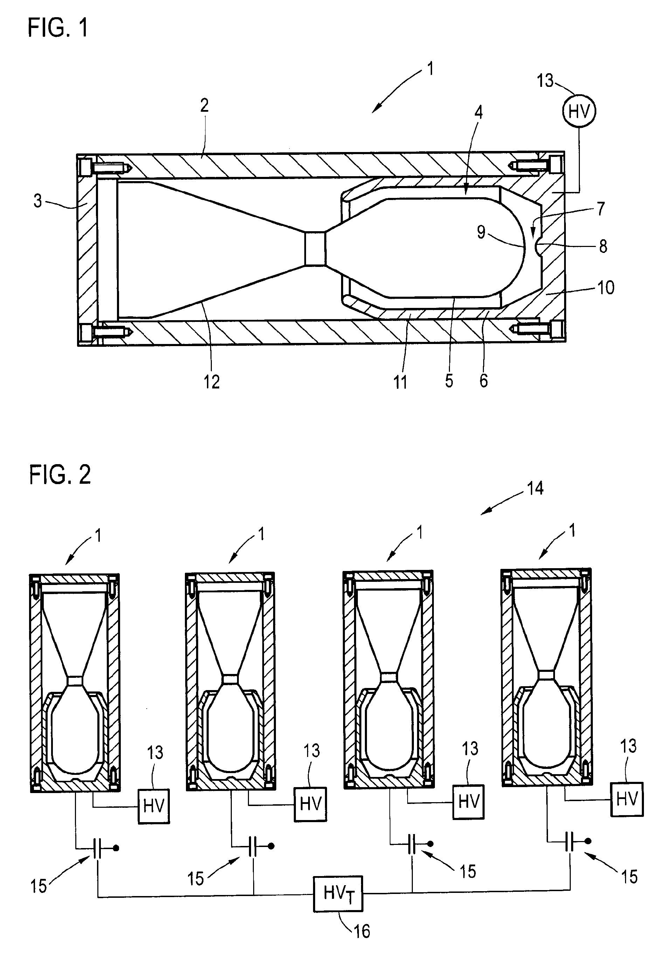

Fig. 1 zeigt einen Mikrowellengenerator 1 in Form einer Prinzipdarstellung. Er besteht aus einem zylindrischen Isoliergehäuse 2, beispielsweise aus Glasfaserverbundwerkstoff, das einerseits über einen Abschlussdeckel 3, vorzugsweise ebenfalls aus einem Isoliermaterial, geschlossen ist (das Vorsehen eines Abschlussdeckels ist fakultativ). Im Inneren des Gehäuses befindet sich ein Resonator 4, bestehend aus zwei einander gegenüberliegenden Elektroden 5, 6, wobei die Elektrode 5, also die innere Elektrode, im Wesentlichen keulenförmig ausgeführt ist, mit einem mittleren zylindrischen Abschnitt konstanten Durchmessers. Sie bildet die innere Elektrode. Demgegenüber ist die äußere Elektrode 6 topfartig ausgeführt. Bei beiden handelt es sich um rotationssymmetrische Bauteile.

Die beiden Elektroden 5, 6 sind über eine Funkenstrecke 7 voneinander getrennt, welche Funkenstrecke 7 über zwei Zündelektroden 8, 9 ausgebildet ist. Exemplarisch ist hier die eine Zündelektrode 8 als vorspringende rundliche Erhebung ausgeführt und an der äußeren Elektrode 6 vorgesehen. Die Zündelektrode 9 ist als integrale Fläche an der Kugelkappe der inneren Elektrode 5 vorgesehen.

Im Inneren des Gehäuses ist mit hohem Druck, üblicherweise einem Druck von mindestens einigen bar bis zumeist maximal 100 bar, ein gasförmiges Dielektrikum, beispielsweise SF₆ aufgenommen.

Die äußere Elektrode 6 weist wie beschrieben eine topfartige Form auf. Sie besteht aus einem Bodenabschnitt 10, an dem axial vorspringend ein hohlzylindrischer Elektrodenabschnitt 11 vorgesehen ist, der den keulenartigen Resonator respektive die Elektrode 5, an der eine Antenne 12 als abstrahlendes Element in Form einer trichterartigen Struktur vorgesehen ist, umgreift. Der Elektrodenabschnitt 11 weist im mittleren Bereich, wo er den zylindrischen mittleren Abschnitt der Elektrode 5 umgreift, ebenfalls einen konstanten Durchmesser auf. Über den Bodenabschnitt 10 der Elektrode 6 erfolgt der Abschluss des Gehäuses an dieser Seite. Die Elektrode 6 ist vorzugsweise als einstückiges metallenes Bauteil ausgeführt, auch die Elektrode 5 ist als metallenes, hohles Bauteil ausgeführt.

Wie Fig. 1 zeigt, sind beide Elektroden 5, 6 in den jeweiligen mittleren Bereichen im Wesentlichen zylindrisch ausgeführt, ihre Form ist also einander angepasst, der Abstand ist in diesem Bereich konstant. Die grundsätzliche Auslegung der Elektroden insbesondere in diesem Bereich hinsichtlich einer konstanten Beabstandung sollte so sein, dass sich ein im Wesentlichen konstantes Impedanzverhalten ergibt. Im Endbereich verjüngen sich sowohl die innere Elektrode 5 als auch die äußere Elektrode 6, sie schnüren sich vom Durchmesser her gesehen ein, jedoch nimmt der Abstand zwischen beiden, siehe Fig. 1, zu. Hieraus ergibt sich eine gezielte Impedanzanpassung, es wird ein Impedanzsprung realisiert, an dem ein Teil des schwingenden Stroms reflektiert wird. Über die konkrete, geometriebedingte Impedanzform beziehungsweise den Impedanzverlauf kann die Form und die Dauer der abgestrahlten HPEM-Pulse entsprechend angepasst werden.

Da der Bodenabschnitt 10 der Elektrode 6 gleichzeitig den Gehäuseabschluss bildet, kann hier auf einfache Weise ein Hochspannungsversorgungsmittel, also eine Hochspannungsquelle 13, beispielsweise ein Marx'scher Stoßspannungsgenerator angeschlossen werden. Über diese Hochspannungsquelle 13 wird die resonatorseitige Kondensatorstruktur, gebildet aus den beiden Elektroden 5, 6, aufgeladen (vorzugsweise wird dazu die innere Elektrode 5 auf Masse gelegt; zeichnerisch in Fig. 1 nicht dargestellt), bis erfindungsgemäß eine gezielte, durch direkte Triggerung des Resonators 4 initiierte Endladung über einen Kurzschluss erfolgt, so dass es zu den Entlade- oder Kurzschlussströmen kommt, die oszillierende Schwingungen auf der Elektrode 5 durchführen.

Fig. 2 zeigt eine erfindungsgemäße Vorrichtung 14, umfassend exemplarisch vier Mikrowellengeneratoren 1 beispielsweise der vorbeschriebenen, in Fig. 1 gezeigten Art. Das heißt, dass bezüglich des Aufbaus auf die Ausführungen zu Fig. 1 verwiesen wird. Jedem Mikrowellengenerator 1 ist eine eigene Hochspannungsquelle 13 zugeordnet, über die die jeweilige Kondensatorstruktur aufgeladen wird.

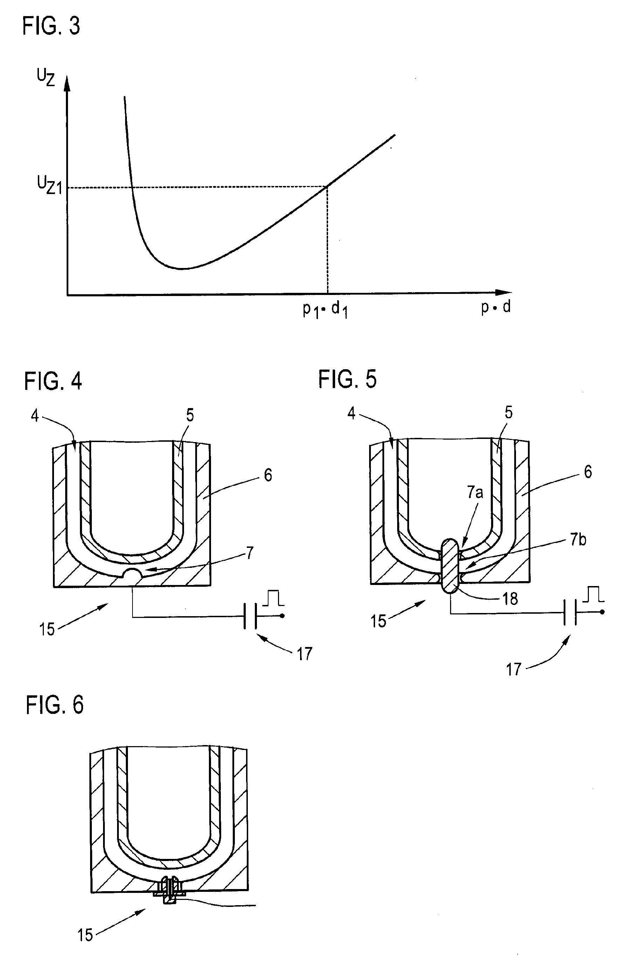

Bei bekannten Mikrowellengeneratoren würde die Aufladung über die Hochspannungsquelle 13 bis zum Erreichen der Durchbruchsspannung der Funkenstrecke 7 erfolgen, wobei diese Durchbruchspannung, auch Zündspannung genannt, abhängig unter anderem vom gegebenen Innendruck wie auch dem Abstand der Zündelektroden 8, 9 ist. Dies ergibt sich aus dem Paschengesetz, die entsprechende Kurve ist exemplarisch in Fig. 3 gezeigt.

Dort ist längs der Abszisse das Produkt aus dem Druck p und dem Elektrodenabstand d aufgetragen, längs der Ordinate die Zündspannung U_{Z}. Der linke, fallende Kurvenast beschreibt Generatoren, die mit Niederdruck arbeiten, der rechte Kurvenast beschreibt den hier gezeigten Fall von Generatoren, die mit hohem Überdruck arbeiten, üblicherweise im Bereich von 10 bis 100 bar. Ersichtlich ist jedem Produkt p · d eine bestimmte Zündspannung zugeordnet, exemplarisch ist hier die Zündspannung U_{Z1} zum Produkt p₁ · d₁ gezeigt. Würde, wie bisher üblich, über die jeweilige Hochspannungsquelle 13 die jeweilige Kondensatorstruktur bei Zünden der Hochspannungsquelle 13 bis U_{Z1} aufgeladen, so kommt es spätestens mit Erreichen von U_{Z1} zu einem Durchschlag der Funkenstrecke 7, damit zum Stromfluss und zur Abstrahlung eines HPEM-Pulses.

Anders jedoch der Betrieb der erfindungsgemäßen Vorrichtung 14. Hier werden die einzelnen Kondensatorstrukturen der einzelnen Mikrowellengeneratoren 1 über die jeweilige Hochspannungsquelle 13 (alternativ könnte allen Mikrowellengeneratoren 1 auch eine gemeinsame, sie aufladende Hochspannungsquelle 13 zugeordnet sein) nur auf eine Spannung aufgeladen, die unterhalb der sich resonatorspezifisch aus dem Paschengesetz ergebenden Zündspannung liegt, wobei die Aufladespannung aus Sicherheitsgründen um wenigstens 10 % vorzugsweise um wenigstens 20 % darunter liegt. Das heißt, dass es allein durch die Aufladespannung nicht zu einem Selbstdurchbruch der jeweiligen Funkstrecke und damit zur Pulserzeugung kommt. Zur eigentlichen Zündung weist jeder Mikrowellengenerator 1 eine Triggereinrichtung 15 auf, über die jeder Resonator individuell getriggert werden kann, mithin also der Durchbruch jeder Funkenstrecke individuell angesteuert und erwirkt werden kann. Hierzu ist eine gemeinsame Steuerungseinrichtung 16 vorgesehen, die alle im System eingebundenen Triggereinrichtungen 15 gemäß eines vorgegebenen Zeitschemas synchronisiert ansteuert, so dass folglich eine hochgenaue zeitliche Auslöseabfolge eingestellt respektive abgearbeitet werden kann und folglich die einzelnen HPEM-Pulse der einzelnen Generatoren 1 exakt synchronisiert erzeugt werden, so dass sie sich nach einem gewünschten Muster überlagern können und eine gezielte Strahlformung, resultierend aus Überlagerungs- oder Reflexionseffekten etc., erreicht werden kann. Dies ist möglich, als im Rahmen des Abgleichs respektive der Ansteuerung der einzelnen Triggervorrichtungen 15 respektive Mikrowellengeneratoren 1 lediglich ein etwaiger Jitter seitens der Funkenstrecken berücksichtigt werden muss, nicht aber irgendwelche zeitkritischen Eigenschaften der Hochspannungsquellen 13, die, wenn sie zünden sollen, um gemäß dem Stand der Technik einen Hochspannungspuls zum Durchbruch der Funkenstrecke zu generieren, einen großen Jitter aufweisen, der es letztlich fast unmöglich macht, eine zeitexakte Synchronisation zu realisieren. Das heißt, dass für die Synchronisation beziehungsweise Phasensteuerung der Wellenfronten der einzelnen von den Generatoren 1 abgegebenen Pulse nur noch der Jitter des jeweiligen DS-Resonators maßgeblich ist.

Die Figuren 4 bis 13 zeigen unterschiedliche Ausgestaltungen möglicher Triggereinrichtungen 15, die je nach Auslegung mit unterschiedlichen Verfahren arbeiten.

Fig. 4 zeigt exemplarisch eine Triggereinrichtung 15, die als einfacher Überspannungstrigger ausgelegt ist. Jeder Überspannungstrigger 15 umfasst ganz grundsätzlich eine die benötigte Triggerspannung erzeugende Hochspannungsquelle 17, die hier exemplarisch mit der gezeigten Kondensatorstruktur dargestellt ist. Die Entladung dieser Hochspannungsquelle 17 wird über die Steuerungseinrichtung 16 gesteuert.

Wie ausgeführt lädt die jeweilige Hochspannungsquelle 13 die jeweilige resonatorseitige Kondensatorstruktur nur auf eine Spannung auf, die deutlich unterhalb der funkenstreckenspezifischen Zündspannung U_{Z} liegt. Über die Triggereinrichtung 15 wird nun zur Erwirkung des Durchschlags über die Funkenstrecke die noch benötigte Zündspannung geliefert, die beispielsweise in einer ähnlichen Größenordnung liegt wie die über die Hochspannungsquelle 13 anliegende Aufladungsspannung. Sobald die Triggerspannung über die Triggereinrichtung 15 angelegt wird, liegt letztlich in der Summe eine hinreichend hohe Gesamtspannung an der Funkenstrecke 7 an, so dass es dort unmittelbar zum Durchschlag kommt, die Kondensatorstruktur entlädt sich abrupt, der Mikrowellenpuls wird erzeugt.

Eine andere Ausgestaltung einer Triggereinrichtung 15 zeigt Fig. 5. Die dortige Triggereinrichtung 15 ist als Feldverzerrungstrigger ausgebildet. Sie umfasst wiederum eine Hochspannungsquelle 17, die die Triggerspannung zur Verfügung stellt. Dort jedoch ist resonatorseitig eine zusätzliche Elektrode 18 vorgesehen, die jeweils eine Durchbrechung in der inneren Elektrode 5 und der äußeren Elektrode 6 durchgreift, wobei in diesem Bereich, da die Elektrode 18 von den beiden anderen Elektroden 5, 6 beabstandet ist, zwei Funkenstrecken 7a, 7b gebildet sind. Mit Anlegen der Triggerspannung zusätzlich zur bereits über die Hochspannungsquelle 13 anliegenden Spannung kommt es in den einzelnen Funkenstrecken 7a, 7b folglich zum Durchschlag, so dass auch hier die Entladung erfolgt, jedoch über die zentrale Elektrode 18. Auch hier liegt die erforderliche Triggerspannung zumindest größenordnungsmäßig im Bereich der Aufladespannung.

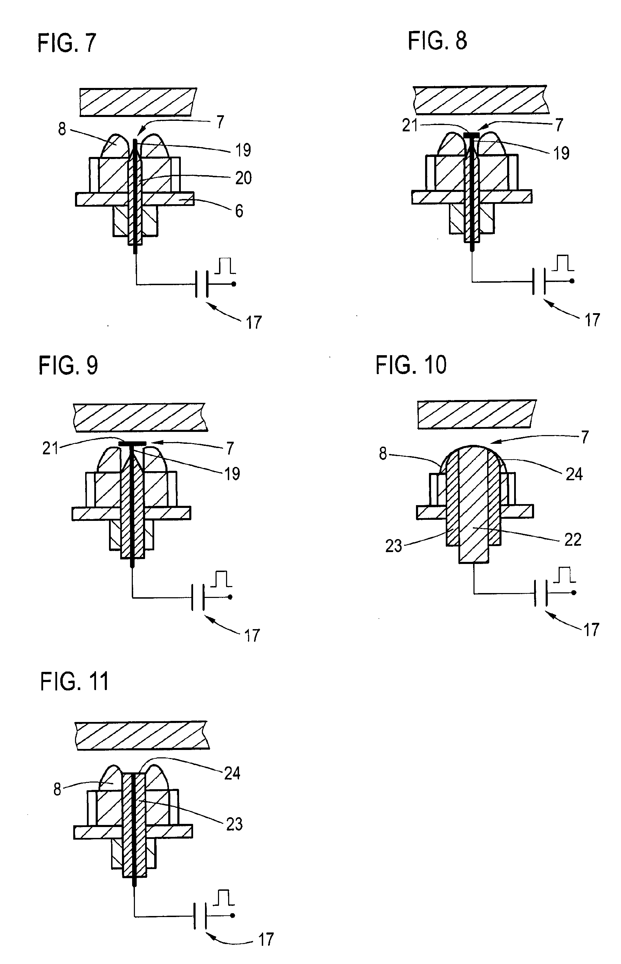

Die Figuren 6 bis 9 zeigen verschiedene Ausführungsformen einer Triggereinrichtung 15 in Form eines Plasmainjektionstriggers. Wie den vergrößerten Darstellungen gemäß den Figuren 7 bis 9, die jeweils Plasmainjektionstrigger zeigen, weist jede solche Triggereinrichtung eine Elektrode 19 auf, die in einem Isolator 20 in den Bereich der Funkenstrecke 7 geführt ist. Das Elektrodenende liegt innerhalb einer hier ringförmigen Zündelektrode 8, die Teil der äußeren Elektrode 6 ist. Über die auch hier vorgesehene Zünd-Hochspannungsquelle 17 wird nun durch Ansteuerung über die gemeinsame Steuerungseinrichtung 16 eine wenngleich relativ niedrige Hochspannung im Bereich weniger kV angelegt. Dies führt dazu, dass es zwischen der Elektrode 19 und der Elektrode 8 zunächst zur lokalen Ausbildung eines Plasmas kommt. Da der Abstand, den der Isolator 20 definiert, relativ gering ist, er liegt typischerweise im Bereich weniger 100 µm, sind folglich zur Ausbildung des Plasmas zwischen diesen beiden Elektroden 8 und 19 nur - verglichen mit der Aufladespannung - geringe Spannungen erforderlich. Sobald sich in diesem Bereich eine Plasmawolke ausbildet, ist folglich die Ladungsträgerinjektion erfolgt, das Plasma breitet sich lawinenmäßig in der Funkstrecke aus, so dass es sodann zum sicheren und definierten Durchschlag kommt.

Die Figuren 7 bis 9 zeigen wie beschrieben unterschiedliche Ausgestaltungen dieses Triggers, wobei sich dort jeweils die Elektrodenform ändert. Während in Fig. 7 eine einfache stab- oder stiftförmige Elektrode 19 vorgesehen ist, weist die Elektrode 19 gemäß Fig.8 eine Abschlussplatte 21 auf, die bei der Elektrode 19 aus Fig. 9 noch größer ausgelegt ist und jeweils einen Schutz des Isolators bietet.

Die Figuren 10 und 11 zeigen zwei Ausgestaltungen von Triggereinrichtungen 15, die als Oberflächengleitfunkentrigger ausgelegt sind. Vorgesehen ist wiederum eine Elektrode 22, die in einem Isolator 23 aufgenommen ist. Die Elektrode 22 endet quasi flächenbündig mit dem Isolator 23, der seinerseits mit seiner Außenfläche 24 unmittelbar an der Zündelektrode 8 anliegt. Wird nun über die Zünd- beziehungsweise Hochspannungsquelle 17 wiederum eine auch hier im Bereich weniger kV liegende Spannung an die Elektrode 22 angelegt, so wandern Ladungsträger über die Isolatoroberfläche 24 zur Elektrode 8, es kommt oberflächenseitig zur Ausbildung einer ersten Plasmawolke, die sich sodann in die Funkenstrecke 7 hineinerstreckt, so dass es zur Zündung kommt.

Fig. 11 zeigt eine auf dem gleichen Funktionsprinzip beruhende Ausgestaltung, wobei hier jedoch eine andere Konfiguration der Elektrode 22 sowie des Isolators 23 und der Zündelektrode 8 vorgesehen ist, das Funktionsprinzip ist jedoch das gleiche.

Vereinfacht wird die Zündung dieses Triggers dadurch, dass sich bereits nach einem ersten Zündvorgang auf der Oberfläche 24 des Isolators eine oder mehrere Spuren einbrennen, die folglich besser leitfähige Kanäle bilden und die Ausbildung des Anfangsplasma vereinfachen.

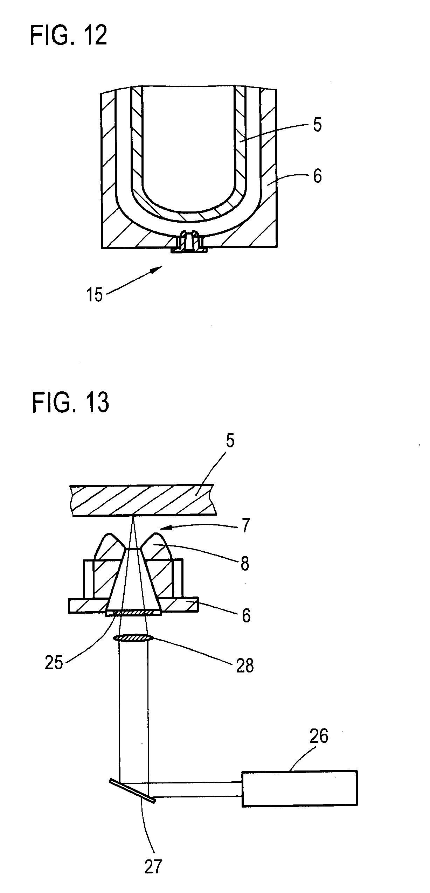

Schließlich zeigen die Figuren 12 und 13 eine Ausgestaltung einer Triggereinrichtung 15 in Form eines optischen Triggers. Dort ist in die äußere Elektrode 6 ein Fenster 25 eingesetzt, dem eine Linse 28 vorgeschaltet ist. Das Fenster 25 befindet sich zentralsymmetrisch zur auch hier als Ring ausgelegten Zündelektrode 8. Über eine Strahlungsquelle 26, hier beispielsweise ein Laser, wird über einen Umlenkspiegel 27 hochenergetisches Licht über die Linse 28 und das Fenster 25 in den Bereich der Funkstrecke 7 eingebracht, woraus die Erzeugung des Plasmas und somit die Zündung resultiert. Beispielsweise ist es möglich, den Strahl auf die Oberfläche der inneren Elektrode 5 zu fokussieren, so dass sich dort ein thermisches Plasma an der Oberfläche ausbildet, das zur Zündung führt. Denkbar ist es aber auch, den Strahl im Volumen der Funkenstrecke 7 zu fokussieren, so dass sich quasi ein induzierter Durchbruch aus dem Volumen heraus ergibt.

Die gezeigten Ausgestaltungen der verschiedenen Triggereinrichtungen 15 sind lediglich exemplarisch, selbstverständlich sind auch andersartig aufgebaute Triggereinrichtungen, soweit es die Geometrie der verwendeten Komponenten als auch das Funktionsprinzip angeht, denkbar. Gemein ist sämtlichen Ausgestaltungen jedoch, dass über diese Triggereinrichtungen selektiv und individuell eine Triggerung unmittelbar innerhalb der Funkenstrecke erfolgt, die sodann zum eigentlichen Durchschlag und damit zur Erzeugung des HPEM-Pulses führt.

## Patentansprüche

1. Vorrichtung zur Erzeugung von Mikrowellen, umfassend mehrere separat ansteuerbare Mikrowellengeneratoren mit jeweils einem Resonator mit jeweils einer Kondensatorstruktur umfassend zwei Elektroden, die über eine Funkenstrecke getrennt sind, sowie den Mikrowellengeneratoren zugeordnete Hochspannungsversorgungsmittel zur Aufladung der einzelnen Kondensatorstrukturen, wobei die jeweilige Kondensatorstruktur über einen Durchschlag der Funkenstrecke entladbar ist,
**dadurch gekennzeichnet,**
**dass** die einzelnen Kondensatorstrukturen über die Hochspannungsversorgungsmittel (13) auf eine Spannung unterhalb der Durchschlagspannung der einzelnen Funkenstrecken (7) aufladbar sind,
und **dass** jeder Funkenstrecke (7) eine Triggereinrichtung (15) zur Auslösung eines Durchschlags der jeweiligen Funkenstrecke (7) zugeordnet ist,
wobei die Triggereinrichtungen (15) über eine gemeinsame Steuerungseinrichtung (16) individuell ansteuerbar sind.

2. Vorrichtung nach Anspruch 1,
**dadurch gekennzeichnet,**
**dass** den Mikrowellengeneratoren (1) ein gemeinsames Hochspannungsversorgungsmittel (13) zugeordnet ist, oder dass jedem Mikrowellengenerator (1) ein eigenes Hochspannungsversorgungsmittel (13) zugeordnet ist.

3. Vorrichtung nach Anspruch 1 oder 2,
**dadurch gekennzeichnet,**
**dass** die Hochspannungsversorgungsmittel (13) die Kondensatorstrukturen auf maximal 90 %, insbesondere nur auf maximal 80 % der resonatorspezifischen Durchschlagspannung aufladen.

4. Vorrichtung nach einem der vorangehenden Ansprüche,
**dadurch gekennzeichnet,**
**dass** die Triggereinrichtungen (15) als elektrische arbeitende Trigger ausgebildet sind.

5. Vorrichtung nach Anspruch 4,
**dadurch gekennzeichnet,**
**dass** die elektrisch arbeitenden Trigger als Überspannungstrigger, Feldverzerrungstrigger, Ladungsträgerinjektionstrigger, Elektronenstrahltrigger oder als Oberflächengleitfunkentrigger ausgebildet sind.

6. Vorrichtung nach einem der Ansprüche 1 bis 3,
**dadurch gekennzeichnet,**
**dass** die Triggereinrichtungen (15) als optisch arbeitende Trigger ausgebildet sind.

7. Vorrichtung nach Anspruch 6,
**dadurch gekennzeichnet,**
**dass** die optisch arbeitenden Trigger als Lasertrigger, Röntgenstrahlungstrigger oder UV- oder VUV-Strahlungstrigger ausgebildet sind.
